(19) Europäisches Patentamt / European Patent Office / Office européen des brevets

(11) **EP 2 782 032 A2**

(12) **EUROPEAN PATENT APPLICATION**

(43) Date of publication:
24.09.2014 Bulletin 2014/39

(51) Int Cl.:
*G06F 17/50* (2006.01)

(21) Application number: 14151684.9

(22) Date of filing: 17.01.2014

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME

(30) Priority: 22.03.2013 JP 2013060708

(71) Applicant: FUJITSU LIMITED
Kawasaki-shi,
Kanagawa 211-8588 (JP)

(72) Inventors:
• Furuya, Hiroyuki
Kawasaki-shi, Kanagawa 211-8588 (JP)

• Ozsuka, Akihiro
Kawasaki-shi, Kanagawa 211-8588 (JP)
• Yamaguchi, Atsushi
Kawasaki-shi, Kanagawa 211-8588 (JP)
• Ueda, Akira
Kawasaki-shi, Kanagawa 211-8588 (JP)
• Nitta, Kazuhiro
Kawasaki-shi, Kanagawa 211-8588 (JP)

(74) Representative: Wilding, Frances Ward
Haseltine Lake LLP
Lincoln House, 5th Floor
300 High Holborn
London WC1V 7JH (GB)

(54) **Analysis model generating program, analysis model generating method, and analysis model generating apparatus**

(57) An analysis model generating apparatus includes a processor that is configured to generate based on three-dimensional design information of an object under analysis, first information that represents a rectangular parallelepiped surrounding the object; generate for each direction of three orthogonal sides of the rectangular parallelepiped indicated by the first information, second information that indicates cross sections of the rectangular parallelepiped orthogonal to the direction; calculate based on the design information and for each of the cross sections indicated by the second information, an index value corresponding to a proportion of the object in a cross section; detect among the cross sections, adjacent cross sections having a difference in the calculated index value greater than a predetermined value; and generate for each of the detected adjacent cross sections, a plate model representative of a plate that is disposed orthogonal to the direction at a position corresponding to the adjacent cross section.

FIG.1

EP 2 782 032 A2

**Description**

FIELD

The embodiments discussed herein are related to an analysis model generating program, an analysis model generating method, and an analysis model generating apparatus.

BACKGROUND

Acoustic analysis using the statistical energy analysis (SEA) method is conventionally performed at the design stage, etc. of an object such as a marine vessel, automobile, building, and industrial product to predict high-frequency range, acoustic vibrations transmitted into the object.

In the acoustic analysis using the SEA method, an object under analysis is modeled. The object is modeled by, for example, dividing the object, which includes an acoustic space, into several SEA elements and establishing a network between the SEA elements, representative of coupling of respective acoustic vibration energies of the divided SEA elements.

For example, a related technique enables high-frequency range, indoor/outdoor vibration and noise analysis for a system that includes a prime mover, a load portion, a structure, a fluid, and a foundation; and as well as monitoring and control to prevent vibration and noise during operation of an automobile from exceeding a reference value (Japanese Laid-Open Patent Publication No. 2001-264156).

However, a problem arises in that if the shape of the noise transmission path is complicated, manually dividing of the object into SEA elements becomes difficult, preventing efficient execution of noise analysis.

SUMMARY

It is desirable to at least solve the above problems in the conventional technologies.

According to an aspect of an embodiment, an analysis model generating program causes a computer to execute a process that includes generating based on three-dimensional design information of an object under analysis, first information that represents a rectangular parallelepiped surrounding the object; generating for each direction of three orthogonal sides of the rectangular parallelepiped indicated by the first information, second information that indicates cross sections of the rectangular parallelepiped orthogonal to the direction; calculating based on the design information and for each of the cross sections indicated by the second information, an index value corresponding to a proportion of the object in a cross section; detecting among the cross sections, adjacent cross sections having a difference in the calculated index value greater than a predetermined value; and generating for each of the detected adjacent cross sections, a plate model representative of a plate that is disposed orthogonal to the direction at a position corresponding to the adjacent cross section.

BRIEF DESCRIPTION OF DRAWINGS

FIG. 1 is an explanatory view of an operation example of an analysis model generating apparatus;
FIG. 2 is an explanatory view of an acoustic analysis example;
FIG. 3 is an explanatory view of a SEA analysis model example;
FIG. 4 is an explanatory view of an analysis example by a SEA method;
FIG. 5 is an explanatory view of an example of an equation representative of energy transmission between SEA elements;
FIG. 6 is an explanatory view of a case example of an allowable minimum SEA element;
FIG. 7 is a block diagram of an example of a hardware configuration of the analysis model generating apparatus;
FIG. 8 is an explanatory view of a CAD data example;
FIG. 9 is a block diagram of a functional configuration example of the analysis model generating apparatus;
FIG. 10 is an explanatory view of a generation example of first CAD data;
FIGs. 11A and 11B are explanatory views of component-removed space model examples;
FIG. 12 is an explanatory view of a generation example of a plate model;
FIG. 13 is an explanatory view of a data structure example of the plate model;
FIG. 14 is an explanatory view of a volume calculation example;
FIG. 15 is an explanatory view of a data structure example of a space model;
FIG. 16 is an explanatory view of a SEA analysis model example of a server apparatus;

FIG. 17 is an explanatory view of a sound source data structure example;

FIG. 18 is a first flowchart of an example of an analysis model generating process procedure by the analysis mode generating apparatus;

FIG. 19 is a second flowchart of the example of the analysis model generating process procedure by the analysis mode generating apparatus;

FIG. 20 is a third flowchart of the example of the analysis model generating process procedure by the analysis mode generating apparatus;

FIG. 21 is a fourth flowchart of the example of the analysis model generating process procedure by the analysis mode generating apparatus;

FIG. 22 is a fifth flowchart of the example of the analysis model generating process procedure by the analysis mode generating apparatus;

FIG. 23 is a sixth flowchart of the example of the analysis model generating process procedure by the analysis mode generating apparatus; and

FIG. 24 is a seventh flowchart of the example of the analysis model generating process procedure by the analysis mode generating apparatus.

DESCRIPTION OF EMBODIMENTS

Embodiments of an analysis model generating program, an analysis model generating method, and an analysis model generating apparatus will be described in detail with reference to the accompanying drawings. Acoustic analysis using the SEA method applied to marine vessels, automobiles, buildings, etc., is applicable to electronic devices. Since marine vessels, automobiles, buildings, etc., are large objects without openings and mainly have noise transmission paths through vibration transmission, transmission power is estimated for each transmission path by the SEA method and countermeasures are taken to change the transmission characteristics to reduce noise.

On the other hand, in the case of the acoustic analysis of electronic devices, etc., a noise source may be a cooling fan, etc. In this case, the main transmission path is not vibration transmission through a sheet metal portion, but rather is sound radiated from an opening for ventilation (intake port, exhaust port). Among electronic devices, information processing devices (such as servers, workstations, and personal computers) are highly densely equipped with cooling fans, hard disk drives, heat sinks, power supply units (PSUs), memories, expansion cards, etc., and have complicated transmission paths for cooling air and fan noise. If a SEA analysis model is manually generated from an electronic device having complicated noise transmission paths, considerable effort is required and if constraint conditions such as size in the SEA analysis model generation are not sufficiently recognized, noise prediction accuracy deteriorates.

Therefore, the analysis model generating apparatus according to this embodiment divides a SEA element at a location where expansion or reduction occurs on a noise transmission path.

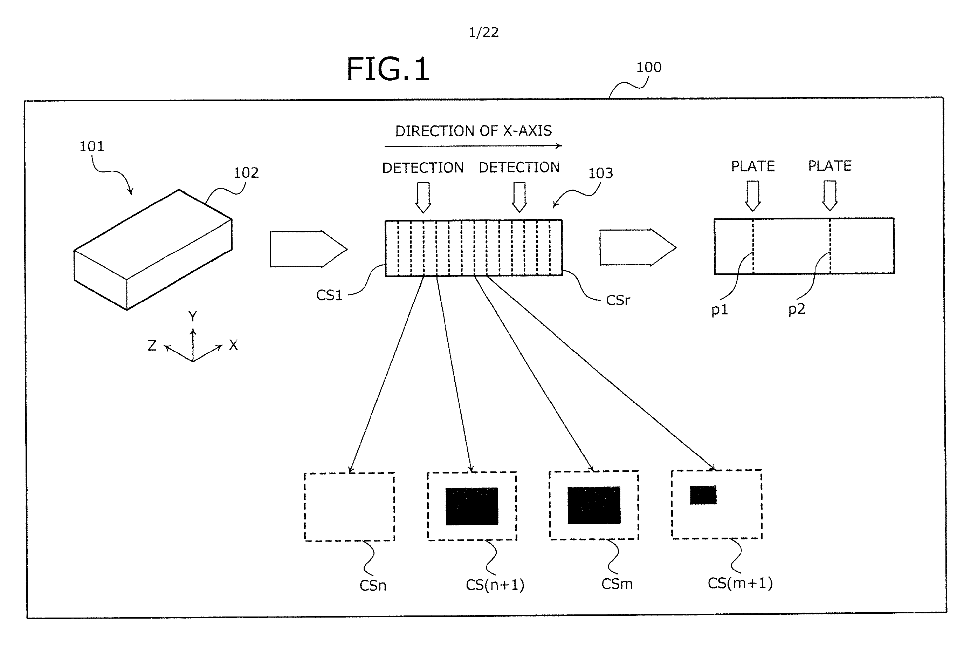

FIG. 1 is an explanatory view of an operation example of an analysis model generating apparatus. An analysis model generating apparatus 100 is a computer that creates a model of an object under analysis to generate an optimum SEA element for acoustic analysis. The object is an object and may be a mechanical product such as a personal computer (PC), a server, a personal digital assistant, an automobile, and a household appliance, a structure such as a building, etc., for example, and is represented by three-dimensional graphics.

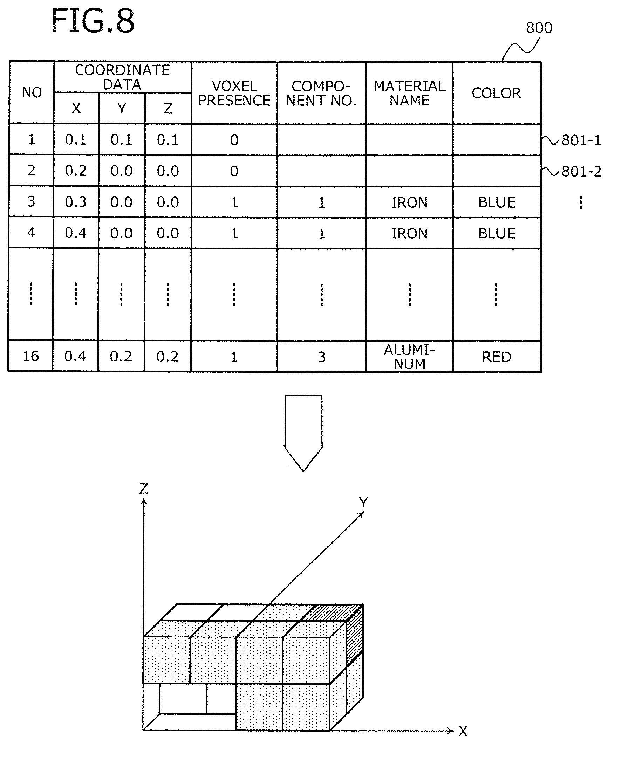

The analysis model generating apparatus 100 generates first information 102 that represents a rectangular parallelepiped surrounding the object, based on three-dimensional design information 101 that represents the object. The three-dimensional design information 101 is three-dimensional computer aided design (CAD) data that includes position data, material data, color data, etc., of components making up the object. A detailed data structure of the CAD data will be described later with reference to FIG. 8. In the three-dimensional design information 101, a three-dimensional orthogonal coordinate system including an X-axis, a Y-axis, and a Z-axis is defined. For example, the design information 101 is stored in a storage device accessible by the analysis model generating apparatus 100. The rectangular parallelepiped surrounding the object is a bounding box, for example.

For each direction of three orthogonal sides of the rectangular parallelepiped indicated by the generated first information 102, the analysis model generating apparatus 100 generates second information 103 indicative of multiple cross sections CS1 to CSr (r≥1) orthogonal to a direction along the rectangular parallelepiped. For example, the analysis model generating apparatus 100 sections the rectangular parallelepiped by a predetermined unit from an end surface orthogonal to a direction of the rectangular parallelepiped to acquire the multiple cross sections CS1 to CSr. In the example of FIG. 1, each side of the rectangular parallelepiped is generated parallel to any one among the X-, Y-, and Z-axes of the three-dimensional orthogonal coordinate system and the respective directions of the three sides are three directions including an X-axis direction, a Y-axis direction, and a Z-axis direction. In the example of FIG. 1, the multiple cross sections CS1 to CSr along the X-axis direction are depicted.

For each of the multiple cross sections CS1 to CSr indicated by the generated second information 103, the analysis model generating apparatus 100 calculates an index value that corresponds to a proportion of the object in the cross section, based on the design information 101. The index value is an area of a portion without the object in the cross section or an area of a portion with the object in the cross section.

The analysis model generating apparatus 100 detects among the multiple cross sections, adjacent cross sections having a difference in the calculated index value greater than a predetermined value. As a result, a location can be detected that has a large change in space without a component acting as a noise transmission path. In the example of FIG. 1, the adjacent cross sections CSn and CS(n+1) are detected and the adjacent cross sections CSm and CS(m+1) are detected.

For each of the detected adjacent cross sections, the analysis model generating apparatus 100 generates a plate model representative of a plate disposed orthogonal to the direction at a position corresponding to the adjacent cross sections. The plate model represents a wall surrounding an acoustic field. In the example of FIG. 1, a plate model representative of a plate p1 that is orthogonal to the X-axis direction is generated at the position corresponding to the adjacent cross sections CSn and CS(n+1), and a plate model representative of a plate p2 that is orthogonal to the X-axis direction is generated at the position corresponding to the adjacent cross sections CSm and CS(m+1).

Although not depicted in FIG. 1, the process of generating multiple cross sections, the process of calculating an index value, the process of detecting adjacent cross sections, and the process of generating a plate model are executed for each direction of the three sides described above. As a result, the plate models representative of plates can be generated in places where walls exist. Therefore, since the dividing operation of SEA elements is automatically conducted, the noise analysis can efficiently be performed. The noise analysis can be performed with consideration given to a sudden change in width of the noise transmission path and the noise analysis accuracy is improved.

Before describing this embodiment in detail, the acoustic analysis of the SEA method will briefly be described.

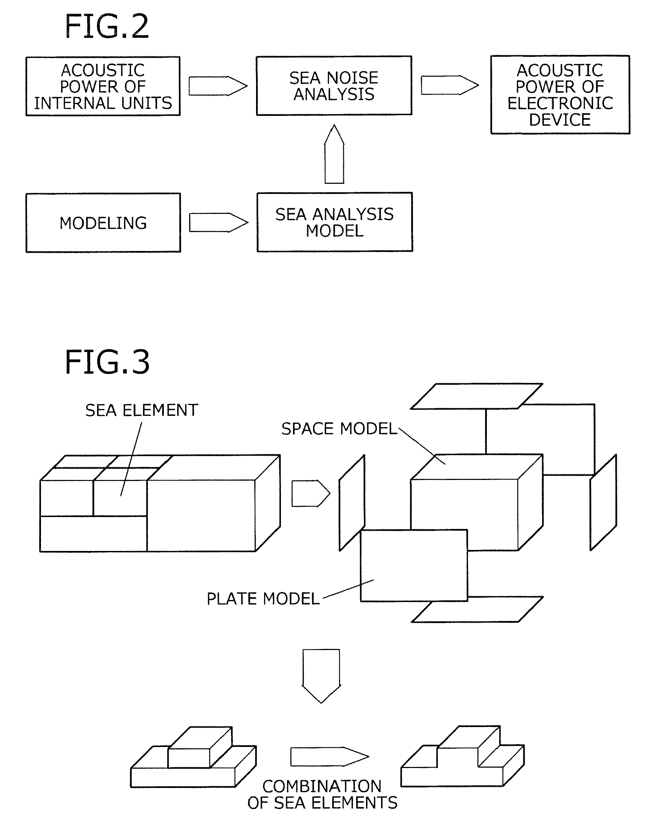

FIG. 2 is an explanatory view of an acoustic analysis example. The acoustic analysis includes, for example, inputting acoustic power generated by internal units such as a cooling fan and an HDD that are noise sources included in an electronic device and a SEA analysis model obtained by modeling the electronic device to predict the acoustic power of the electronic device.

FIG. 3 is an explanatory view of a SEA analysis model example. The SEA analysis model has multiple SEA elements. A SEA element has a space model representative of space and plate models representative of plates surrounding the space. If a SEA element is of a small size, multiple SEA elements are combined. Detailed data structure examples of the plate model and the space model will be described later.

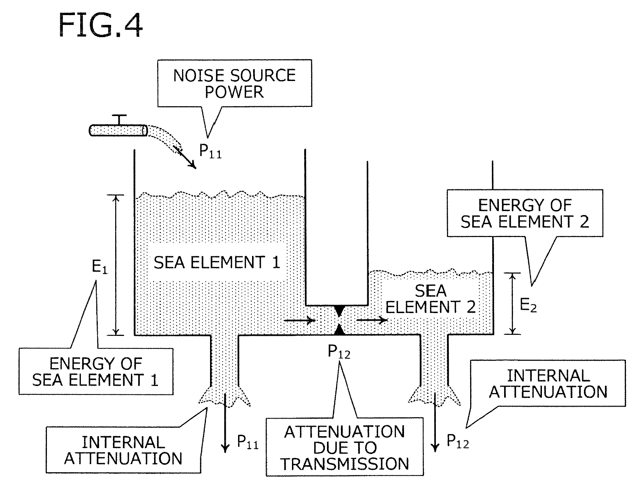

FIG. 4 is an explanatory view of an analysis example by the SEA method. The acoustic analysis by the SEA method includes for each SEA element, calculations for internal attenuation, attenuation due to transmission between adjacent SEA elements, and energy flow between SEA elements. Internal attenuation is attenuation of sound colliding with a wall in an object. Attenuation due to transmission between adjacent SEA elements is attenuation of sound leaking from a hole of a wall. Therefore, it is desirable to divide a SEA element at a place where a wall exists. Attenuation due to transmission is represented by a coupling loss rate and internal attenuation is represented by an internal loss rate.

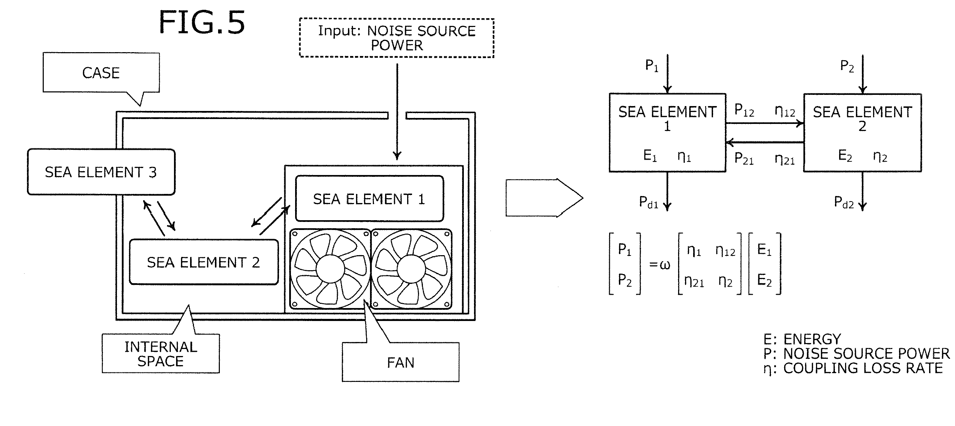

FIG. 5 is an explanatory view of an example of an equation representative of energy transmission between SEA elements. A determinant representative of energy transmission between SEA elements is expressed by energy E, a coupling loss rate $\eta$, and noise source power P.

Equation (1) represents a coupling loss rate $\eta_{SV}$ indicative of attenuation due to energy transmission from a plate to the space representing a sound field, and Equation (2) represents a coupling loss rate $\eta_{VS}$ indicative of attenuation due to energy transmission from a space representing a sound field to a plate:

$$\eta_{SV} = (\rho_V \cdot c_V \cdot \sigma) / (\omega \cdot \rho_S \cdot t) \tag{1}$$

$$\eta_{VS} = (\rho_V \cdot c_V \cdot \sigma \cdot n_S) / (\omega \cdot \rho_S \cdot n_V) \tag{2}$$

Where, $\sigma$ is acoustic radiation efficiency, p is density, $n_V$ is sound field mode density, and $n_S$ is plate mode density. The plate mode density $n_S$ and the sound field mode density $n_V$ are represented by Equations (3) and (4), respectively:

$$n_S = (S \cdot \sqrt{12}) / (4 \cdot \pi \cdot c_L \cdot t) \tag{3}$$

$$n_v = (V \cdot \omega^2) / (2 \cdot \pi^2 \cdot c_v^3) \tag{4}$$

Where, S is surface area, t is plate thickness, c is the acoustic velocity of the medium of the acoustic field element, and V is the volume. The plate thickness, material, internal loss rate, and opening rate or opening area are set for the plate model. The medium and an internal loss rate are set for the space model. The medium is a substance or an object acting as a field that propagates wave motions and, for example, the medium is air, water, or metal. For a space model representative of space that includes a noise source, the acoustic power of the single noise source is set. The internal loss rate indicates a loss due to conversion of vibration energy into thermal energy in an SEA element. In the case of a steel plate with a plate thickness of 1 [mm], the internal loss rate is known and the internal loss rate is $0.041f^{-0.7}$ regardless of the area. If the internal loss rate is not known, the internal loss rate is calculated by Equation (5):

$$\eta = \frac{cS\bar{\alpha}}{4V\omega} \tag{5}$$

Where, V is the volume, S is the surface area, and c is the acoustic velocity of the medium of the acoustic field element. Additionally, $\alpha$ (in Equation (5), a prolonged sound mark is added to the top of $\alpha$) is the average sound absorption rate. The average sound absorption rate is calculated by Equation (6). In Equation (6), f is frequency.

$$\bar{\alpha} = 18 \times 10^{-5}\sqrt{f} \tag{6}$$

The acoustic analysis with the SEA method is based on the premise that energy of each mode is equal in an SEA element. To ensure the prediction accuracy of the acoustic analysis, the size of an SEA element is set to a size that satisfies Equation (7).

$$n = \int_{f0}^{f1} \left( \frac{4\pi f^3 V}{3c^3} + \frac{\pi f^2 A}{4c^2} + \frac{P}{8c}f \right) df > 1 \tag{7}$$

In Equation (7), c is the acoustic velocity of the medium of the acoustic field element, V is the volume, A is the area, P is the peripheral length, f0 is the lower limit cutoff frequency, and f1 is the upper limit cutoff frequency.

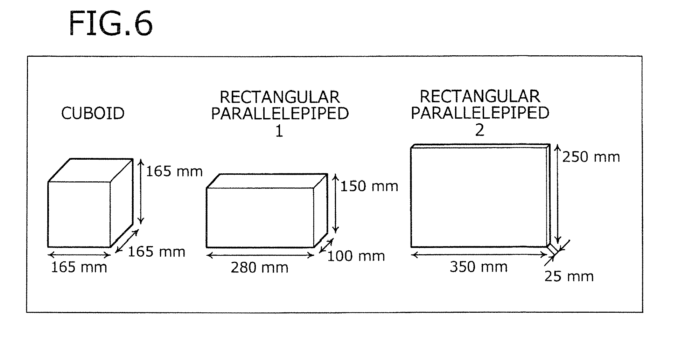

FIG. 6 is an explanatory view of a case example of an allowable minimum SEA element. For example, assuming that the number of modes included in one SEA element is one or more in a 1.6 [kHz] band (1/3 octave band), a size of each SEA element is set to satisfy sizes depicted in FIG. 6.

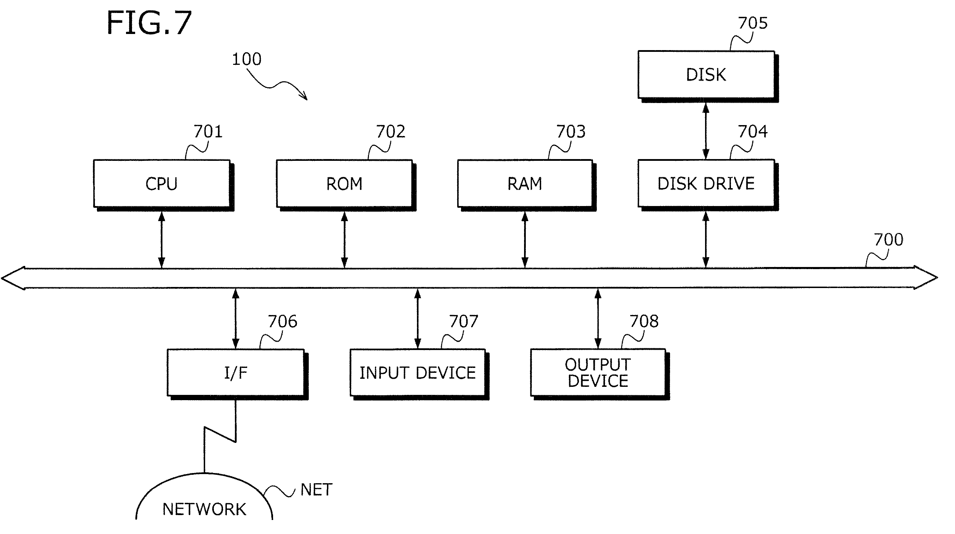

FIG. 7 is a block diagram of an example of a hardware configuration of the analysis model generating apparatus. As depicted in FIG. 7, an analysis model generating apparatus 100 includes a CPU 701, ROM 702, RAM 703, a disk drive 704, and a disk 705. The analysis model generating apparatus 100 has an I/F 706, an input device 707, and an output device 708. The components are respectively connected by a bus 700.

The CPU 701 governs overall control of the analysis model generating apparatus 100. The ROM 702 stores programs such as a boot program. The RAM 703 is used as a work area of the CPU 701. The disk drive 704, under the control of the CPU 701, controls the reading and writing of data with respect to the disk 705. The disk 705 stores data written thereto under the control of the disk drive 704. Examples of the disk 705 include a magnetic disk, an optical disk, and the like.

The I/F 706 is connected to a network NET such as a local area network (LAN), a wide area network (WAN), and the Internet, via a communication line, and is further connected to other apparatuses through the network NET. The I/F 706 administers an internal interface with the network NET and, controls the input and output of data with respect to external apparatuses. A modem, a LAN adapter, and the like may be adopted as the I/F 706.

The input device 707 is an interface through which various types of data is input via user operation of a keyboard, mouse, and the like. The input device 707 may further taken in images and moving pictures from a camera. The input device 707 may further take in audio from a microphone. The output device 708 is an interface that outputs data under the instruction of the CPU 701. Examples of the output device 708 include a display, a printer, and the like.

FIG. 8 is an explanatory view of a CAD data example. Three-dimensional CAD data is information indicative of an object under analysis and the example of FIG. 8 is depicted as a simple data example to facilitate understanding. CAD data 800 is represented as a set of voxels that are cubes. The CAD data 800 has fields for the number (No), the coordinate data, the presence/absence of a voxel, the component number, the material name, and the color. Information is set in the fields and registered as records (801-1, 801-2, ...). When the CAD data 800 is read by a CAD tool, a three-dimensional figure represented by the CAD data 800 is displayed on a display, etc., as depicted in a lower portion of FIG. 8. The CAD data 800 is stored in a storage device such as the ROM 702 and the disk 705.

In the number field, information for identifying records is set. In the coordinate data field, X-coordinate data, Y-coordinate data, and Z-coordinate data are set.

In the voxel presence/absence field, the presence/absence of a voxel representative of a component at a position indicated by the coordinate data is set. In the component number field, identification information of a component indicated by a voxel is set. In the material name field, a material name of a component represented by a voxel is set. In the color field, color information of a component represented by a voxel is set.

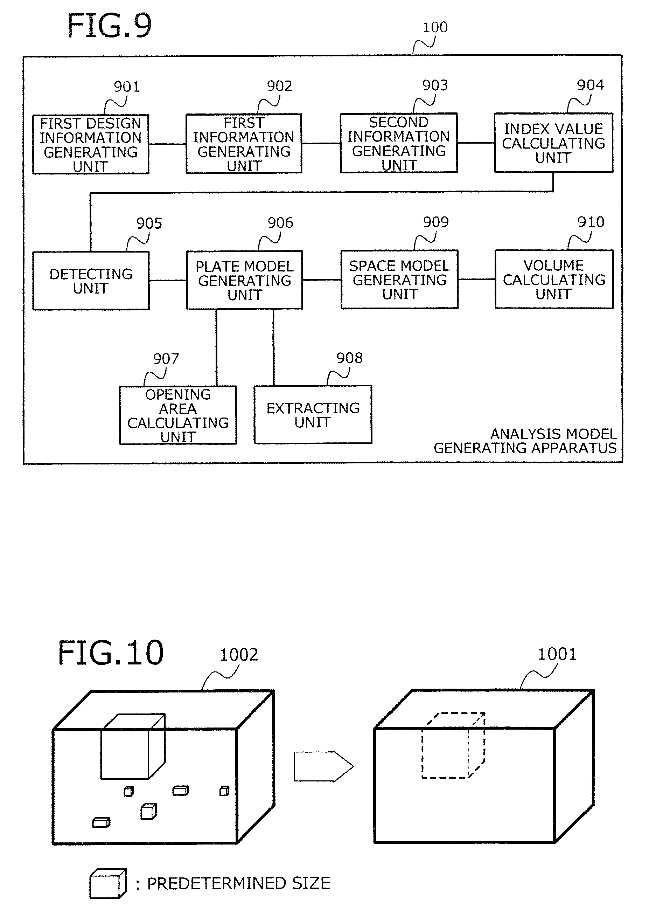

FIG. 9 is a block diagram of a functional configuration example of the analysis model generating apparatus. The analysis model generating apparatus 100 includes a first design information generating unit 901, a first information generating unit 902, a second information generating unit 903, an index value calculating unit 904, a detecting unit 905, and a plate model generating unit 906. The analysis model generating apparatus 100 includes an opening area calculating unit 907, an extracting unit 908, a space model generating unit 909, and a volume calculating unit 910. The processes of the units from the first design information generating unit 901 to the volume calculating unit 910 are coded in a calculation program stored in a storage device accessible by the CPU 701. The CPU 701 reads the calculation program from the storage device and executes the processes coded in a test supporting program. As a result, the processes of the units from the first design information generating unit 901 to the volume calculating unit 910 are implemented. Process results of the units from the first design information generating unit 901 to the volume calculating unit 910 are stored to a storage device such as the RAM 703 and the disk 705, for example.

First, the first design information generating unit 901 generates first CAD data indicative of a first object to be analyzed acquired from a second object indicated by second CAD data by excluding from among multiple components included in the second object, the components having a size less than or equal to a predetermined size. The size may be a capacity, for example. The predetermined size is specified by a designer in advance and is stored in a storage device such as the disk 705. The predetermined size is defined based on Equation (7) described above, for example. Both the first CAD data and the second CAD data have the same data structure as the CAD data 800 depicted in FIG. 8.

FIG. 10 is an explanatory view of a generation example of the first CAD data. For example, the first design information generating unit 901 calculates based on the component numbers included in second CAD data 1002, the capacity of a component from the number of voxels, which are representative of each component. The first design information generating unit 901 determines whether the capacity of each component is less than or equal to a predetermined capacity. The first design information generating unit 901 acquires from the second CAD data 1002, a record having the component number indicative of a component determined as having a capacity less than or equal to the predetermined capacity. The first design information generating unit 901 generates first CAD data 1001 having the voxel presence/absence field changed from "presence" to "absence" for the acquired data. In FIG. 10, all the small components included in the second object indicated by the second CAD data 1002 are deleted.

The first information generating unit 902 generates first information that represents a rectangular parallelepiped surrounding the first object, based on the first CAD data 1001. The first information is referred to as a component-removed space model A1. The first information generating unit 902 generates a component-removed space model A2 that represents a rectangular parallelepiped surrounding the second object, based on the second CAD data 1002.

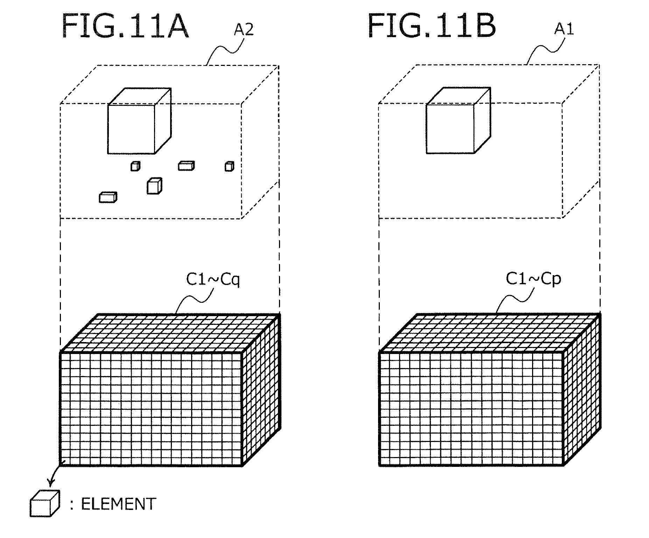

FIGs. 11A and 11B are explanatory views of component-removed space model examples. The component-removed space model A1 is a model that represents the rectangular parallelepiped surrounding the first object indicated by the first CAD data 1001. The component-removed space model A1 represents space without the first object in the rectangular parallelepiped surrounding the first object. The component-removed space model A2 is a model representative of the rectangular parallelepiped surrounding the second object indicated by the second CAD data 1002. The component-removed space model A2 represents space without the second object in the rectangular parallelepiped surrounding the second object. The component-removed space model A1 and the component-removed space model A2 are represented by being sectioned into multiple elements C1 to Cp and multiple elements C1 to Cq, respectively, in a mesh shape as in the case of voxels. Each element has information indicative of whether the element is a space without a component included in each object.

The second information generating unit 903, the index value calculating unit 904, the detecting unit 905, and the plate model generating unit 906 execute processes of the units for each direction of three orthogonal sides of the rectangular parallelepiped represented by the generated component-removed space model A1. It is assumed that the rectangular parallelepiped is created to have each side of the rectangular parallelepiped in parallel with any one of the X-, Y-, and Z-axes and the respective directions of the three sides are the X-axis direction, the Y-axis direction, and the Z-axis direction.

The second information generating unit 903 generates second information indicative of multiple cross sections orthogonal to the direction of the rectangular parallelepiped represented by the component-removed space model A1 for each direction. For example, the second information generating unit 903 may generate the second information indicative of multiple cross sections orthogonal to the direction of the rectangular parallelepiped represented by the component-removed space model A1 along a dimension of the elements of the component-removed space model A1 for each direction.

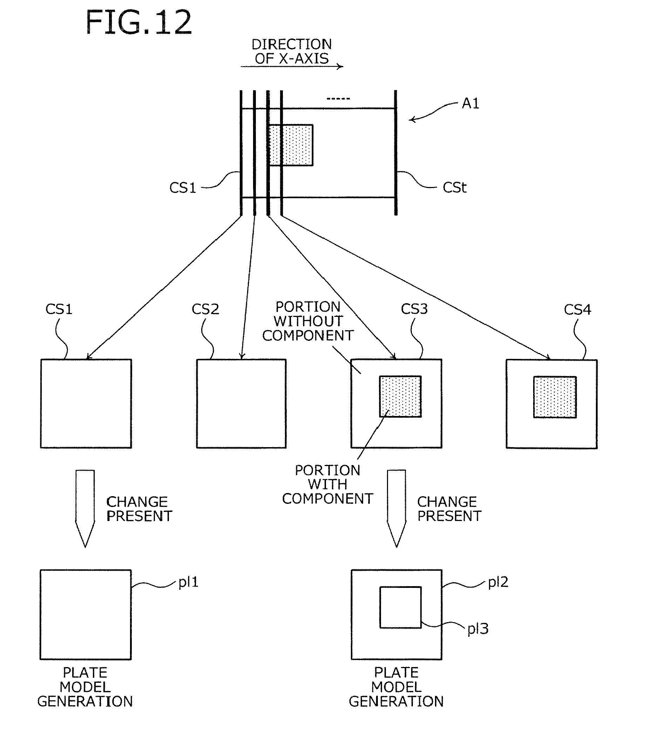

FIG. 12 is an explanatory view of a generation example of a plate model. In the example of FIG. 12, multiple cross sections CS1 to CSt orthogonal to the X-axis direction are depicted. Although not depicted, the second information indicative of the multiple cross sections CS1 to CSt has coordinate data of the vertices of the cross sections.

For each of the multiple cross sections CS1 to CSt indicated by the generated second information, the index value calculating unit 904 calculates an index value corresponding to a proportion of the object in the cross section. As described above, for example, the index value is an area of the portion without the first object in the cross section. Alternatively, for example, the index value is an area of the portion with the first object in the cross section. In the example of FIG. 12, the index value is an area of the portion without the first object in the cross section.

For each cross section, the index value calculating unit 904 calculates an area of the portion without the first object in the cross section, based on the number of elements included in the cross section of the rectangular parallelepiped represented by the component-removed space model A1 and the number of elements having information set to indicate an absence of a component among the elements included in the cross section.

The detecting unit 905 detects among the multiple cross sections CS1 to CSt, adjacent cross sections having a difference in the calculated index value greater than a predetermined value. The predetermined value is assumed to be determined in advance by a user and stored in a storage device such as the disk 705. In the example of FIG. 12, the detecting unit 905 also detects an endmost cross section of the multiple cross sections CS1 to CSt. The detecting unit 905 calculates a difference in the index value of adjacent cross sections in order in the X-axis direction to detect cross sections with a larger difference.

The plate model generating unit 906 generates a plate model indicative of a plate disposed orthogonal to the direction at a position corresponding to the adjacent cross sections for each of the detected adjacent cross sections. Since attention is focused on the X-axis direction in FIG. 12, the plate model generating unit 906 generates a plate model indicative of a plate disposed orthogonally to the X-axis direction

In the example of FIG. 12, the endmost cross section, i.e., the cross section CS1 is detected and a plate model representative of a plate Pl1 is generated at a position corresponding to the cross section CS1. The index value of the cross section CS1 is compared with the index value of the cross section CS2 and no plate model is generated due to the absence of a change.

The plate model generating unit 906 generates a plate model representative of a plate that includes a portion with the first object in one cross section of the adjacent cross sections and a plate model representative of a plate that includes a portion without the first object in the one cross section at the position corresponding to the adjacent cross sections. In the example of FIG. 12, the index value of the cross section CS2 is compared with the index value of the cross section CS3 and because of a large change, a plate model representative of a plate pl2 that includes the portion without the component in the cross section CS3 is generated along with a plate model representative of a plate pl3 that includes the portion with the component in the cross section CS3. If the portion with a component is divided into multiple portions, the plate model generating unit 906 may generate a plate model for each portion with the component.

The opening area calculating unit 907 calculates for each of the generated plate models, a value based on an area of a portion without the second object indicated by the second CAD data 1002 in the plate represented by the plate model. The value based on an area of a portion without the second object (hereinafter referred to as an "opening area") is the opening area itself or is an opening rate indicative of a proportion of the portion without the second object in the plate represented by the plate model.

For each of the plate models, the extracting unit 908 extracts from the second CAD data 1002, a physical property value of the component having the largest area among the components located at the same position as the plate represented by the plate model, among the multiple components included in the second object indicated by the second CAD data 1002. For each of the generated plate models, the extracting unit 908 extracts from the second CAD data 1002, a physical property value of the component having the largest proportion of the portion overlapping the plate, among the components at least partially overlapping the plate represented by the plate model, among the components included in the second object. The physical property value of the component may be a material of the component or a thickness of the component, for example. The generated plate model, the calculated value based on an area of the portion without the first object, and the physical property value of the component are correlated and stored in the storage device.

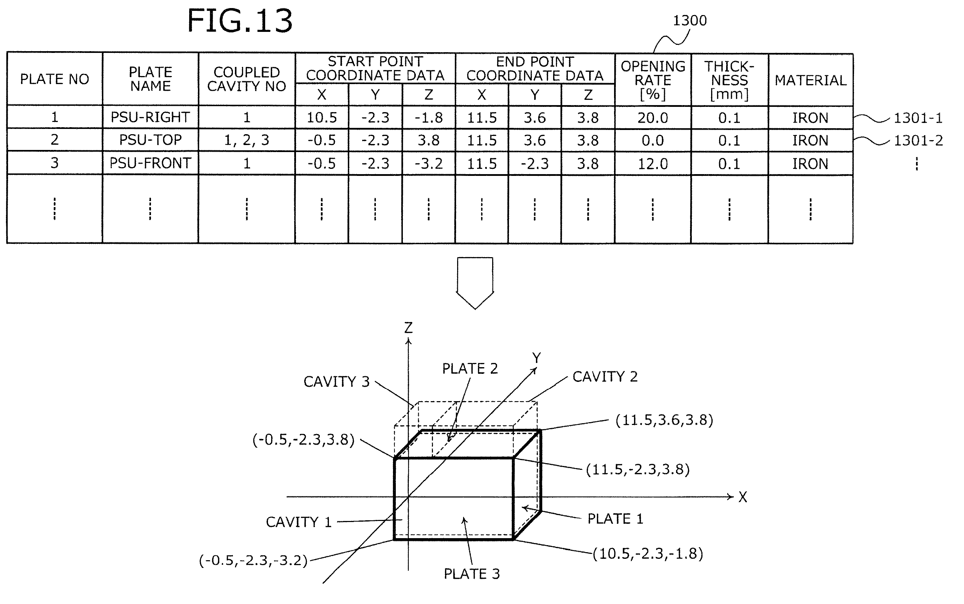

FIG. 13 is an explanatory view of a data structure example of the plate model. In a database 1300, each record is information related to one plate model. The database 1300 has fields for the plate number, the plate name, the coupled cavity number, the start point coordinate data, the end point coordinate data, the opening rate, the thickness, and the material. Information is set in the fields and registered as records (1301-1, 1301-2, ...). The database 1300 is stored in a storage device such as the disk 705.

In the plate number field, a number for identifying a plate model is set. In the plate name field, a name of a component located at the position of a plate represented by the plate model is set. In the coupled cavity number, a number for identifying a space model representative of a space coupled to a plate represented by a plate model is set.

In the opening rate field, an opening rate of the plate represented by the plate model is set as the index value corresponding to an area of the portion without the first object. An opening area may be set instead of the opening rate. In the thickness field, the thickness of the plate represented by the plate model is set. For example, the thickness of a component located at the same position as the plate represented by the plate model may be set in the thickness field. In the material field, the material of the component located at the same position as the plate represented by the plate model is set.

The plate model generating unit 906 sets information in the database 1300 each time a plate model is generated. In the opening rate field, "- (Null)" is set in the initial state, and the opening rate is calculated and set by the opening area calculating unit 907. In the material and thickness fields, "- (Null)" is set in the initial state, and the material and the thickness are extracted and set from the second CAD data 1002 by the extracting unit 908.

The space model generating unit 909 generates a space model representative of a space, based on a rectangular parallelepiped surrounded by plates represented by the generated plate models. When generating a space model, the space model generating unit 909 registers into the database 1300, the number of the space model representative of space coupled to the plates represented by the plate models.

For each of the generated space models, the volume calculating unit 910 calculates the volume of the portion without the second object in the space represented by the space model, based on the volume of the space represented by the space model and the volume of the portion with the second object in the space represented by the space model. The generated space model and the calculated volume are correlated and stored in a storage device.

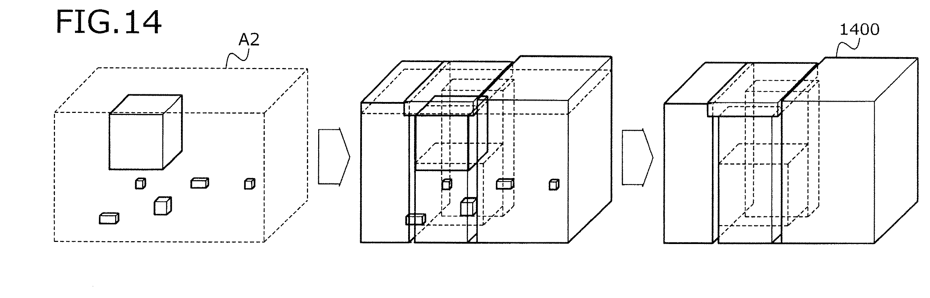

FIG. 14 is an explanatory view of a volume calculation example. For example, in the space represented by the component-removed space model A2, the volume calculating unit 910 calculates the volume of a portion without an object in the spaces represented by multiple space models 1400, based on the number of elements having information set to indicate the absence of the object in a portion of the space represented by the generated multiple space models 1400.

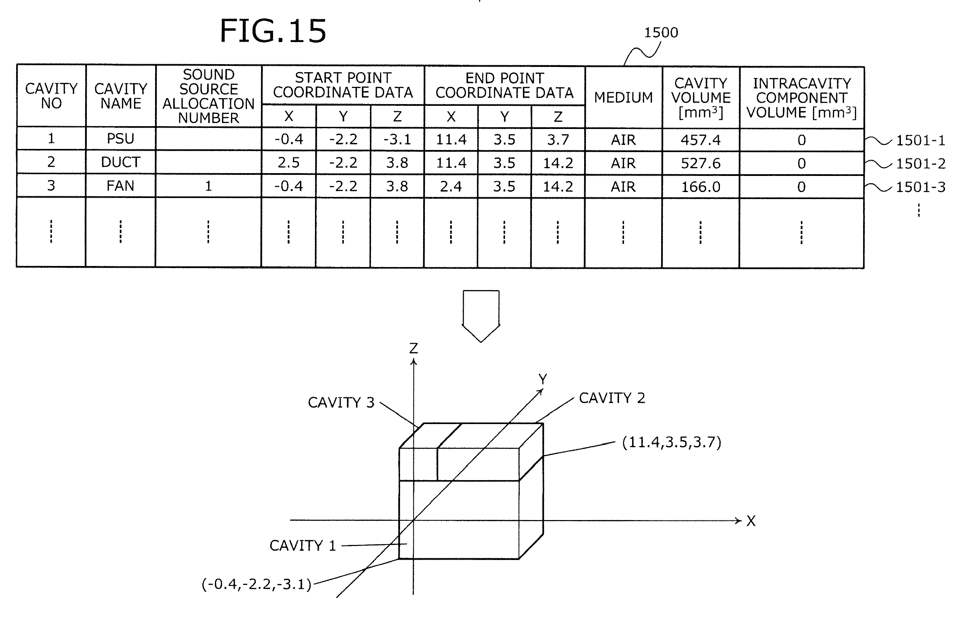

FIG. 15 is an explanatory view of a data structure example of the space model. In a database 1500, each record is information related to one space model. The database 1500 has fields for the cavity number, the cavity name, the sound source allocation number, the start point coordinate data, the end point coordinate data, the medium, the cavity volume, and the intracavity component volume. Information is set in the fields and registered as records (1501-1, 1501-2, 1501-3, ...). The database 1500 is stored in a storage device such as the disk 705.

In the cavity number field, a number for identifying a space model is set. In the cavity name field, a name of a component is set that has the largest proportion of the space among the components present in the space represented by the space model. In the sound source allocation number field, a number for identifying a sound source described later is set if a component indicated by the name set in the cavity name field acts as a sound source.

The start point coordinate data are set as coordinate data of respective points having the smallest X-, Y-, and Z-coordinates among the vertices of the rectangular parallelepiped represented by the space model in the orthogonal coordinate system consisting of the X-, Y-, and Z-axes. The end point coordinate data are set as coordinate data of respective points having the largest X-, Y-, and Z-coordinates among the vertices of the rectangular parallelepiped represented by the space model in the orthogonal coordinate system consisting of the X-, Y-, and Z-axes.

In the medium field, the medium of the space represented by the space model is set. For example, the medium may be air or water. In the cavity volume field, the volume of a portion without a component in the space represented by the space model is set. In the intracavity component volume field, the volume of a portion with a component in the space represented by the space model is set.

The space model generating unit 909 sets information in the database 1500 each time a space model is generated. In the cavity volume and intracavity component volume fields, "- (Null)" is set in the initial state, and the volumes are calculated and set by the volume calculating unit 910.

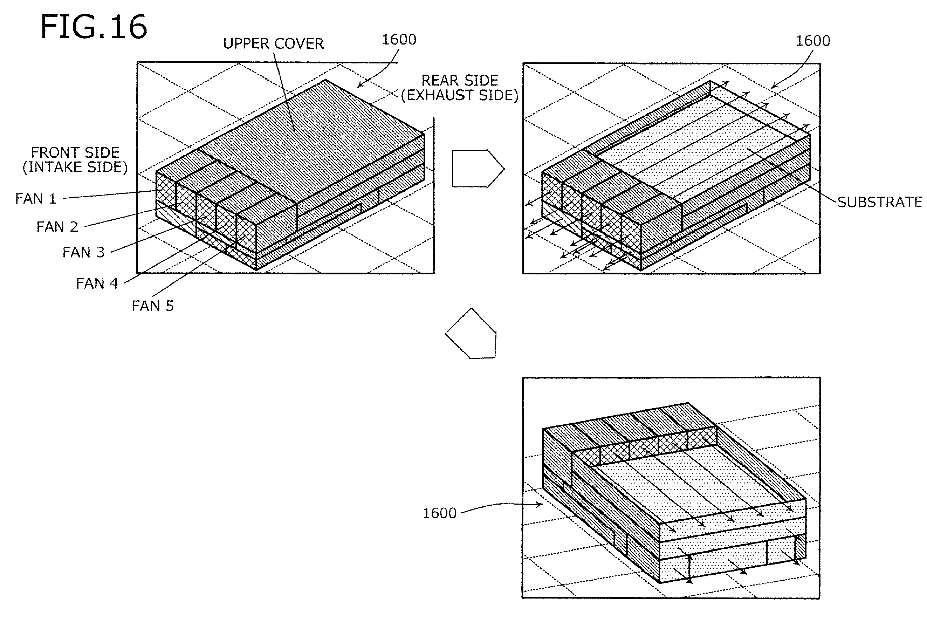

FIG. 16 is an explanatory view of a SEA analysis model example of a server apparatus. A SEA analysis model 1600 is acquired by modeling the server apparatus by the analysis model generating apparatus 100. Two SEA analysis models 1600 on the right side correspond to an example when a plate model representative of an upper cover is removed from the SEA analysis model 1600 on the left side.

Although flows of noise are complicated in such a manner that numerous acoustic rays extend outward from the server apparatus while being irregularly reflected, with a portion of energy being reflected at an opening end and reentering the server apparatus, a simplified noise flow is indicated by arrows in FIG. 16. In the example of FIG. 16, a plate with coarse diagonal lines has a larger opening rate, while a plate with finer diagonal lines has a smaller opening rate. As depicted, since the diagonal lines are coarse, the opening rate is smaller in the upper cover, while for exhaust-side components toward which noise from fans flows, the opening rate is larger since the diagonal lines are finer. As in the SEA analysis model 1600 depicted on the right side with the plate model representative of the upper cover removed, the plate models representative of the plates are generated at locations where the shape of a noise path changes, and no plate model representative of a plate is generated at locations where the shape of a noise path does not change.

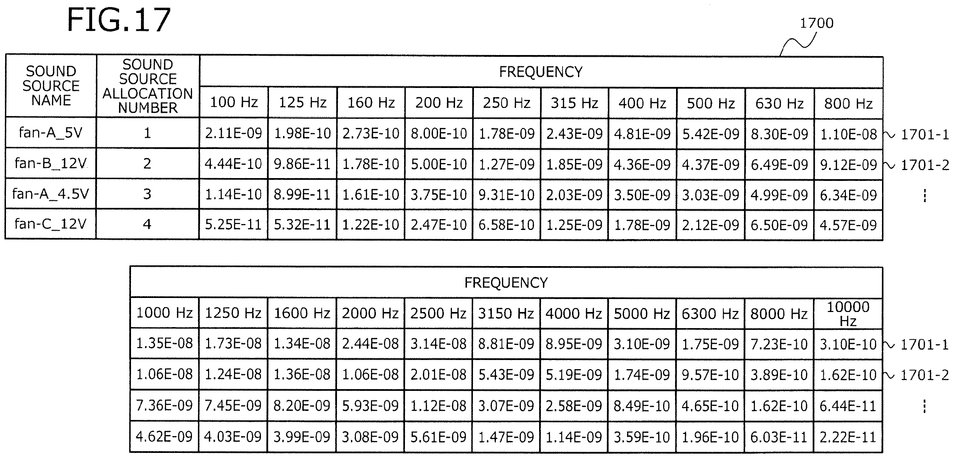

FIG. 17 is an explanatory view of a sound source data structure example. A database 1700 has acoustic power at operation points for each sound source. The database 1700 has fields of the sound source name, the sound source allocation number and the acoustic power of each frequency. Information is set in the fields and registered as records (1701-1, 1701-2, ...). The database 1700 is stored in the storage device such as the disk 705.

In the sound source name field, a name indicative of a sound source is set. In the acoustic power field of each frequency, sound power [W] of a sound source at an operation point is set. A frequency range is from 100 [Hz] to 10000 [Hz]. For example, the sound source allocation number included in the data base 1700 is correlated to the sound source allocation number included in the data base 1500.

The SEA acoustic analysis is performed by using the database 1300 in which the information on the plate models is set, the database 1500 in which the information on the space models is set, and the database 1700 in which the information on the sound source power is set.

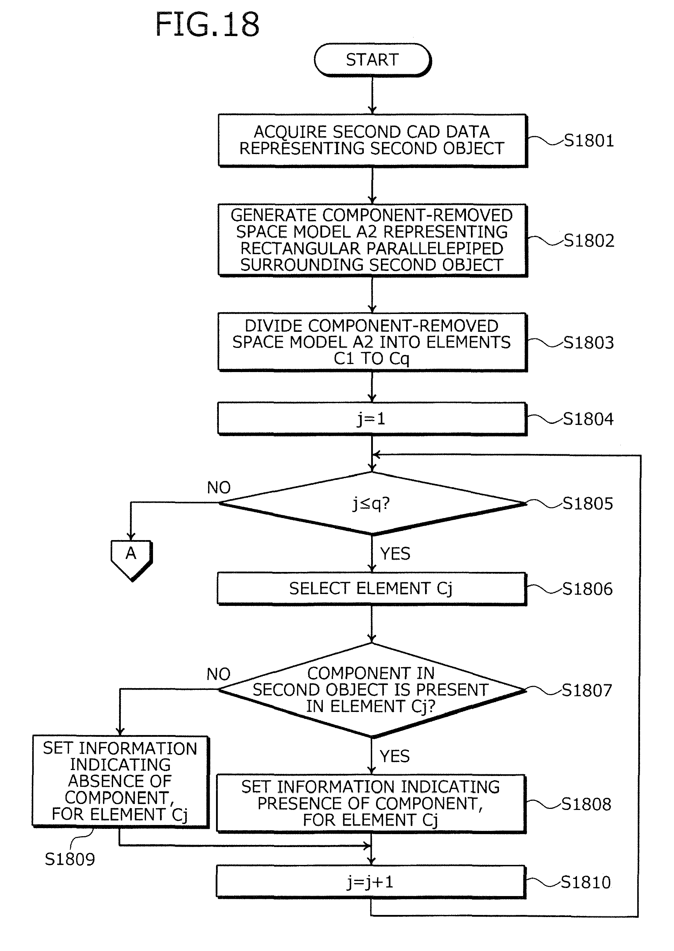

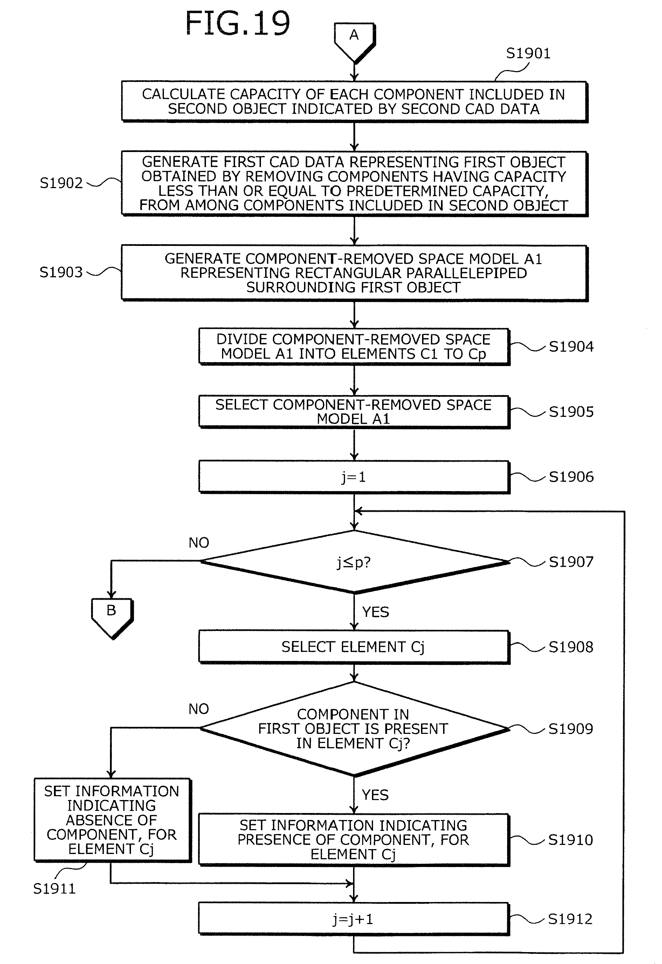

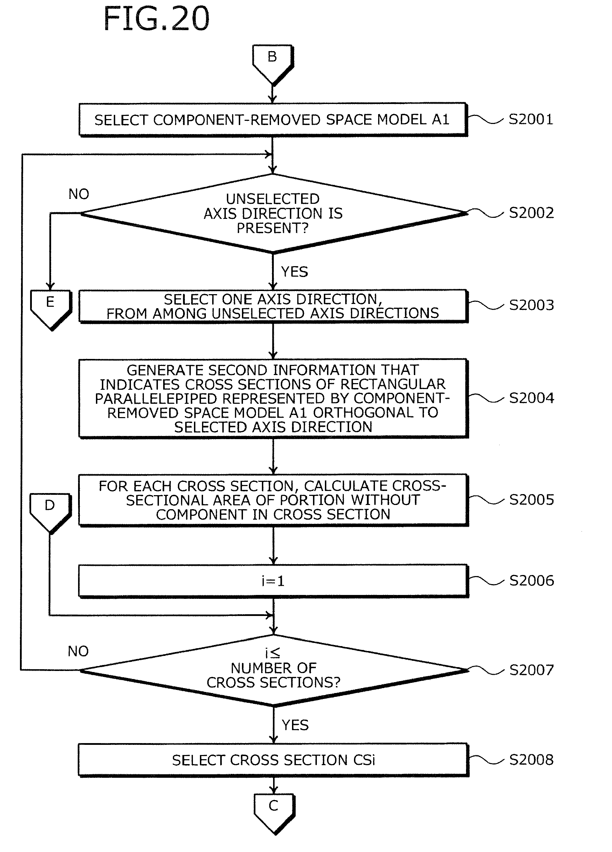

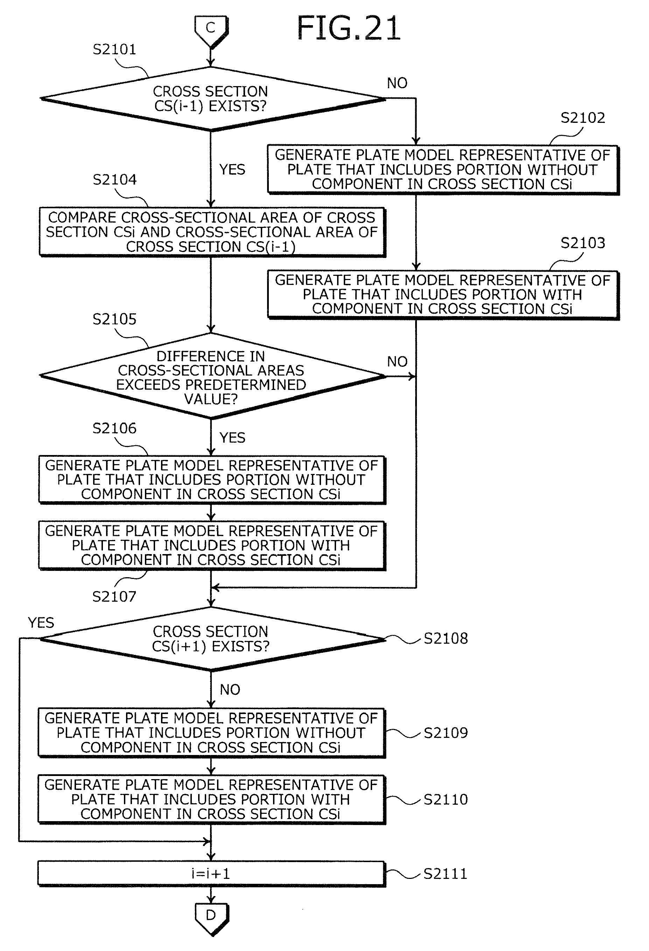

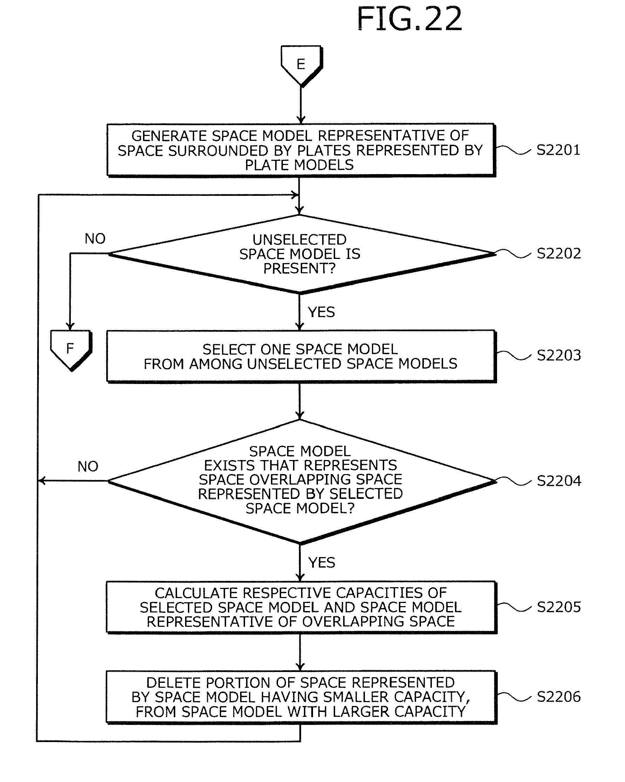

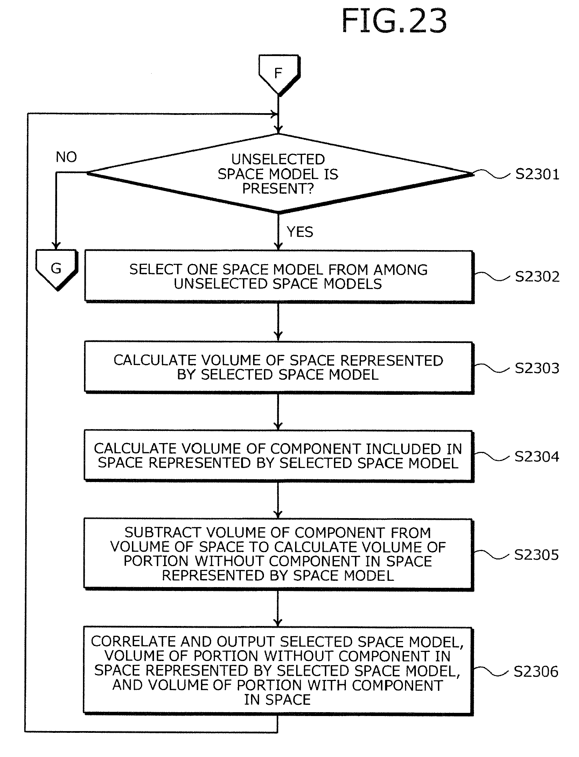

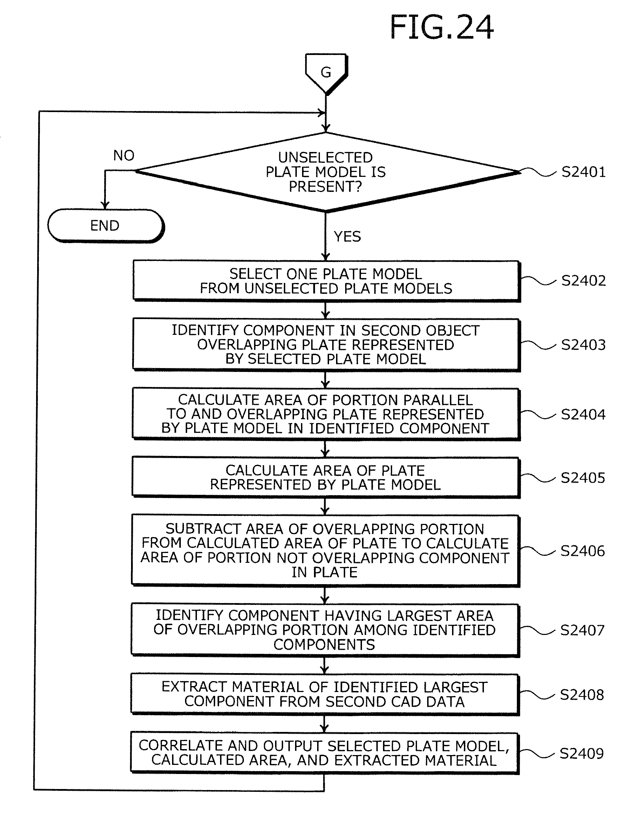

FIGs. 18, 19, 20, 21, 22, 23, and 24 are flowcharts of an example of an analysis model generating process procedure by the analysis mode generating apparatus. The analysis model generating apparatus 100 acquires the second CAD data 1002 that represents the second object (step S1801) and generates the component-removed space model A2 representing the rectangular parallelepiped surrounding the second object (step S1802). The analysis model generating apparatus 100 divides the component-removed space model A2 into the elements C1 to Cq (step S1803) and sets j=1 (step S1804).

The analysis model generating apparatus 100 determines whether $j \leq q$ is satisfied (step S1805). If $j \leq q$ is satisfied (step S1805: YES), the analysis model generating apparatus 100 selects the element Cj (step S1806) and determines whether a component in the second object is present in the element Cj (step S1807). If a component in the second object is present in the element Cj (step S1807: YES), the analysis model generating apparatus 100 sets information indicating the presence of a component, for the element Cj (step S1808) and proceeds to step S1810.

If a component in the second object is not present in the element Cj (step S1807: NO), the analysis model generating apparatus 100 sets information indicating the absence of a component, for the element Cj (step S1809) and goes to step S1810. After step S1808 or S1809, the analysis model generating apparatus 100 sets j=j+1 (step S1810) and returns to step S1805.

If $j \leq q$ is not satisfied (step S1805: NO), the analysis model generating apparatus 100 calculates the capacity of each component included in the second object indicated by the second CAD data 1002 (step S1901). The analysis model generating apparatus 100 generates the first CAD data 1001 representing the first object obtained by removing the components having a capacity less than or equal to a predetermined capacity, from among the components included in the second object (step S1902) and generates the component-removed space model A1 representing the rectangular parallelepiped surrounding the first object (step S1903).

The analysis model generating apparatus 100 divides the component-removed space model A1 into the elements C1 to Cp (step S1904) and selects the component-removed space model A1 (step S1905). The analysis model generating apparatus 100 sets j=1 (step S1906) and determines whether $j \leq p$ is satisfied (step S1907). If $j \leq p$ is satisfied (step S1907: YES), the analysis model generating apparatus 100 selects the element Cj (step S1908) and determines whether a component in the first object is present in the element Cj (step S1909).

If a component in the first object is present in the element Cj (step S1909: YES), the analysis model generating apparatus 100 sets information indicating the presence of a component, for the element Cj (step S1910) and goes to step S1912. If a component in the first object is not present in the element Cj (step S1909: NO), the analysis model generating apparatus 100 sets information indicating the absence of a component, for the element Cj (step S1911) and proceeds to step S1912. After step S1910 or S1911, the analysis model generating apparatus 100 sets j=j+1 (step S1912) and returns to step S1907.

If $j \leq p$ is not satisfied (step S1907: NO), the analysis model generating apparatus 100 selects the component-removed space model A1 (step S2001) and determines whether an unselected axis direction is present (step S2002). If an unselected axis direction is present (step S2002: YES), the analysis model generating apparatus 100 selects one axis direction, from among unselected axis directions (step S2003).

The analysis model generating apparatus 100 generates second information that indicates multiple cross sections of the rectangular parallelepiped represented by the component-removed space model A1 orthogonal to the selected axis direction (step S2004) and for each cross section, calculates a cross-sectional area of a portion without a component in the cross section (step S2005). The analysis model generating apparatus 100 sets i=1 (step S2006) and determines whether i≤the number of the cross sections is satisfied (step S2007). If i≤the number of the cross sections is not satisfied (step S2007: NO), the analysis model generating apparatus 100 returns to step S2002.

If i≤the number of the cross sections is satisfied (step S2007: YES), the analysis model generating apparatus 100 selects the cross section CSi (step S2008) and determines whether the cross section CS(i-1) exists (step S2101). If the cross section CS(i-1) does not exist (step S2101: NO), the analysis model generating apparatus 100 generates a plate model representative of a plate that includes the portion without the component in the cross section CSi (step S2102), generates a plate model representative of a plate that includes the portion with the component in the cross section CSi (step S2103), and proceeds to step S2108.

If the cross section CS(i-1) exists (step S2101: YES), the analysis model generating apparatus 100 compares the cross-sectional area of the cross section CSi with the cross-sectional area of the cross section CS(i-1) (step S2104) and determines whether the difference in the cross-sectional areas exceeds a predetermined value (step S2105). If the difference in the cross-sectional areas does not exceed the predetermined value (step S2105: NO), the analysis model generating apparatus 100 proceeds to step S2108. If a difference in the cross-sectional areas exceeds the predetermined value (step S2105: YES), the analysis model generating apparatus 100 generates a plate model representative of a plate that includes the portion without the component in the cross section CSi (step S2106). The analysis model generating apparatus 100 generates a plate model representative of a plate that includes the portion with the component in the cross section CSi (step S2107) and determines whether the cross section CS(i+1) exists (step S2108).

If the cross section CS(i+1) exists (step S2108: YES), the analysis model generating apparatus 100 proceeds to step S2111. If the cross section CS(i+1) does not exist (step S2108: NO), the analysis model generating apparatus 100 generates a plate model representative of a plate that includes the portion without the component in the cross section CSi (step S2109) and generates a plate model representative of a plate that includes the portion with the component in the cross section CSi (step S2110). The analysis model generating apparatus 100 sets i=i+1 (step S2111) and returns to step S2007.

If an unselected axis direction is not present at step S2002 (step S2002: NO), the analysis model generating apparatus 100 generates a space model representative of space surrounded by the plates represented by the plate models (step S2201). The analysis model generating apparatus 100 determines whether an unselected space model is present (step S2202). If an unselected space model is present (step S2202: YES), the analysis model generating apparatus 100 selects one space model from among unselected space models (step S2203). The analysis model generating apparatus 100 determines whether a space model exists that represents space overlapping with the space represented by the selected space model (step S2204).

If a space model representative of overlapping space does not exist (step S2204: NO), the analysis model generating apparatus 100 returns to step S2202. If a space model representative of overlapping space exists (step S2204: YES), the analysis model generating apparatus 100 calculates respective capacities of the selected space model and the space model representative of the overlapping space (step S2205). For example, in the case of cubes, the analysis model generating apparatus 100 can calculate the respective capacities of the selected space model and the space model representative of the overlapping space from vertical, horizontal, and height sizes. The analysis model generating apparatus 100 deletes a portion of the space represented by the space model having a smaller capacity, from the space model with a larger capacity (step S2206) and returns to step S2202. Instead of steps S2204, S2205, and S2206, the analysis model generating apparatus 100 may calculate the capacity from the number of meshes included in the selected space model.

If an unselected space model is not present at step S2202 (step S2202: NO), the analysis model generating apparatus 100 newly determines whether an unselected space model is present (step S2301). If an unselected space model is present (step S2301: YES), the analysis model generating apparatus 100 selects one space model from unselected space models (step S2302) and calculates the volume of the space represented by the selected space model (step S2303).

The analysis model generating apparatus 100 calculates the volume of the component included in the space represented by the selected space model, based on the component-removed space model A2 (step S2304). The analysis model generating apparatus 100 subtracts the volume of the component from the volume of the space to calculate the volume of the portion without the component in the space represented by the space model (step S2305). The analysis model generating apparatus 100 outputs the selected space model, the volume of the portion without the component in the space represented by the selected space model, and the volume of the portion with the component in the space in a correlated manner (step S2306) and returns to step S2301.

If an unselected space model is not present (step S2301: NO), the analysis model generating apparatus 100 determines whether an unselected plate model is present (step S2401). If an unselected plate model is present (step S2401: YES), the analysis model generating apparatus 100 selects one plate model from unselected plate models (step S2402).

The analysis model generating apparatus 100 identifies a component in the second object overlapping the plate represented by the selected plate model (step S2403) and calculates the area of a portion parallel to and overlapping the plate represented by the plate model in the identified component (step S2404). The analysis model generating apparatus 100 calculates the area of the plate represented by the plate model (step S2405) and subtracts the area of the overlapping portion from the calculated area of the plate to calculate an area of a portion not overlapping the component in the plate (step S2406). The area calculated at step S2406 is the opening area of the plate represented by the selected plate model.

The analysis model generating apparatus 100 identifies the component having the largest area of the overlapping portion among the identified components (step S2407) and extracts the material of the identified largest component from the second CAD data 1002 (step S2408). The analysis model generating apparatus 100 outputs the selected plate model, the calculated area, and the extracted material in a correlated manner (step S2401) and returns to step S2401. If an unselected plate model is not present (step S2401: NO), a sequence of the process is terminated.

As described above, the analysis model generating apparatus 100 according to this embodiment detects adjacent cross sections having large change in the proportion occupied by a component, among the multiple cross sections of the rectangular parallelepiped surrounding the object and divides the SEA elements according to the position of the detected cross sections. As a result, an analysis model can be provided automatically that is sectioned at a location estimated to have a different sound field and the noise analysis can be performed efficiently. The noise analysis can be performed with consideration given to a sudden change in width of the noise transmission path, whereby the noise analysis accuracy is improved, enabling the manual operation time to be reduced.

The analysis model generating apparatus 100 generates a plate model representative of a plate that includes a portion with a component in one cross section of the detected adjacent cross sections and a plate model representative of a plate that includes a portion without the component in the one cross section. As a result, the SEA elements can be divided at a position where a component acting as a wall exists, among the multiple components in the object.

The analysis model generating apparatus 100 calculates an area of the portion without the component in the cross section as an index value corresponding to a proportion of the component in the cross section. Alternatively, the analysis model generating apparatus calculates an area of the portion with the component in the cross section as an index value corresponding to a proportion of the component in the cross section. As a result, the adjacent cross sections having a large change in the proportion occupied by the component can be detected by a simple calculation.

The analysis model generating apparatus 100 generates a plate model after removing small components. As a result, the time consumed for generating the SEA analysis model is reduced. Since each SEA element is formed into a simple shape, the number of combinations between SEA elements is made smaller and the SEA analysis time is reduced.

The analysis model generating apparatus 100 generates a space model representative of the space surrounded by the plates represented by the generated plate models to calculate the volume of a portion without the component in the space model. As a result, the efforts of manual operation can be spared and the noise analysis can be performed efficiently.

The analysis model generating apparatus 100 calculates for each plate model, an opening area of a plate represented by the plate model. The analysis model generating apparatus extracts a physical property value set for the plate for each plate model. As a result, the efforts of manual operation can be spared and the noise analysis can be performed efficiently.

The analysis model generating method described in the present embodiment may be implemented by executing a prepared program on a computer such as a personal computer and a workstation. The program is stored on a non-transitory, computer-readable recording medium such as a hard disk, a flexible disk, a CD-ROM, an MO, and a DVD, read out from the computer-readable medium, and executed by the computer. The program may be distributed through a network such as the Internet.

According to an aspect of the embodiments, noise analysis can be performed efficiently.

All examples and conditional language provided herein are intended for pedagogical purposes of aiding the reader in understanding the invention and the concepts contributed by the inventor to further the art, and are not to be construed as limitations to such specifically recited examples and conditions, nor does the organization of such examples in the specification relate to a showing of the superiority and inferiority of the invention. Although one or more embodiments of the present invention have been described in detail, it should be understood that the various changes, substitutions, and alterations could be made hereto without departing from the spirit and scope of the invention.

## Claims

1. An analysis model generating program that causes a computer to execute a process comprising:

generating, based on three-dimensional design information of an object under analysis, first information that represents a rectangular parallelepiped surrounding the object;

generating, for each direction of three orthogonal sides of the rectangular parallelepiped indicated by the first information, second information that indicates a plurality of cross sections of the rectangular parallelepiped orthogonal to the direction;

calculating, based on the design information and for each of the cross sections indicated by the second information, an index value corresponding to a proportion of the object in a cross section;

detecting, among the cross sections, adjacent cross sections having a difference in the calculated index value greater than a predetermined value; and

generating, for each of the detected adjacent cross sections, a plate model representative of a plate that is disposed orthogonal to the direction at a position corresponding to the adjacent cross section.

2. The analysis model generating program according to claim 1, wherein
the generating the plate model includes generating, for each of the adjacent cross sections, a plate model representative of a plate that includes a portion with the object in one cross section of the adjacent cross sections and a plate model representative of a plate that includes a portion without the object in the one cross section, at the position corresponding to the adjacent cross section.

3. The analysis model generating program according to claim 1 or 2, wherein the index value corresponding to a proportion of the object is an area of the portion without the object in the cross section.

4. The analysis model generating program according to claim 1 or 2, wherein the index value corresponding to a proportion of the object is an area of the portion with the object in the cross section.

5. The analysis model generating program according to any preceding claim, the process further comprising:

generating the design information as first design information that represents the object as a first object, by removing components having a size less than or equal to a predetermined size, from among a plurality of components included in a second object indicated by second design information;
wherein the generating the first information includes generating, based on the generated first design information, the first information that represents a rectangular parallelepiped surrounding the first object.

6. The analysis model generating program according to any preceding claim, the process further comprising:

generating a space model representative of a space surrounded by the plates represented by the generated plate models; and
calculating, for each of the generated space models, a volume of a portion without the object in the space represented by the space model.

7. The analysis model generating program according to any preceding claim, the process further comprising:

calculating, for each of the generated plate models, a value based on an area of a portion without the object in the plate represented by the plate model.

8. The analysis model generating program according to any preceding claim, wherein
the design information has, for each of the components included in the object, a physical property value of the component, and
the process further comprising:

extracting, for each of the generated plate models and from the design information, a physical property value of a component having a largest proportion of the portion overlapping the plate, among components that at least partially overlap the plate represented by the plate model and that are among the components included in the object.

9. An analysis model generating method that is executed by a computer, the analysis model generating method comprising:

generating, based on three-dimensional design information of an object under analysis, first information that represents a rectangular parallelepiped surrounding the object;

generating, for each direction of three orthogonal sides of the rectangular parallelepiped indicated by the first information, second information that indicates a plurality of cross sections of the rectangular parallelepiped orthogonal to the direction;

calculating, based on the design information and for each of the cross sections indicated by the second information, an index value corresponding to a proportion of the object in a cross section;

detecting, among the cross sections, adjacent cross sections having a difference in the calculated index value greater than a predetermined value; and

generating, for each of the detected adjacent cross sections, a plate model representative of a plate that is disposed orthogonal to the direction at a position corresponding to the adjacent cross section.

10. An analysis model generating apparatus comprising:

a first information generating unit (902) that, based on three-dimensional design information of an object under analysis, is configured to generate first information that represents a rectangular parallelepiped surrounding the object;

a second information generating unit (903) that, for each direction of three orthogonal sides of the rectangular parallelepiped indicated by the first information, is configured to generate second information that indicates a plurality of cross sections of the rectangular parallelepiped orthogonal to the direction;

an index value calculating unit (904) that, based on the design information and for each of the cross sections indicated by the second information, is configured to calculate an index value corresponding to a proportion of the object in a cross section;

a detecting unit (905) that, among the cross sections, is configured to detect adjacent cross sections having a difference in the calculated index value greater than a predetermined value; and

a plate model generating unit (906) that, for each of the detected adjacent cross sections, is configured to generate a plate model representative of a plate that is disposed orthogonal to the direction at a position corresponding to the adjacent cross section.

# FIG.1

EP 2 782 032 A2

EP 2 782 032 A2

# FIG.2

```
┌──────────────┐        ┌──────────────┐        ┌──────────────┐
│   ACOUSTIC   │        │              │        │   ACOUSTIC   │
│   POWER OF   │  ⇨     │  SEA NOISE   │  ⇨     │   POWER OF   │
│INTERNAL UNITS│        │   ANALYSIS   │        │  ELECTRONIC  │
│              │        │              │        │    DEVICE    │
└──────────────┘        └──────────────┘        └──────────────┘
                              ⇧
┌──────────────┐        ┌──────────────┐
│              │        │ SEA ANALYSIS │
│   MODELING   │  ⇨     │    MODEL     │
│              │        │              │
└──────────────┘        └──────────────┘
```

# FIG.3

SEA ELEMENT

SPACE MODEL

PLATE MODEL

COMBINATION
OF SEA ELEMENTS

15

# FIG.4

NOISE SOURCE
POWER

$P_{11}$

ENERGY OF
SEA ELEMENT 2

SEA ELEMENT 1

SEA
ELEMENT 2

$E_1$

$E_2$

ENERGY OF
SEA ELEMENT 1

$P_{12}$

INTERNAL
ATTENUATION

INTERNAL
ATTENUATION

$P_{11}$

ATTENUATION
DUE TO
TRANSMISSION

$P_{12}$

# FIG.5

Input: NOISE SOURCE POWER

CASE

SEA ELEMENT 3

SEA ELEMENT 1

SEA ELEMENT 2

INTERNAL SPACE

FAN

$P_1$

$P_2$

SEA ELEMENT 1 $\quad P_{12} \quad \eta_{12} \quad$ SEA ELEMENT 2

$E_1 \quad \eta_1 \qquad P_{21} \quad \eta_{21} \qquad E_2 \quad \eta_2$

$P_{d1}$

$P_{d2}$

$$\begin{bmatrix} P_1 \\ P_2 \end{bmatrix} = \omega \begin{bmatrix} \eta_1 & \eta_{12} \\ \eta_{21} & \eta_2 \end{bmatrix} \begin{bmatrix} E_1 \\ E_2 \end{bmatrix}$$

E: ENERGY
P: NOISE SOURCE POWER
η: COUPLING LOSS RATE

EP 2 782 032 A2

# FIG.6

CUBOID

RECTANGULAR
PARALLELEPIPED
1

RECTANGULAR
PARALLELEPIPED
2

165 mm

165 mm

165 mm

150 mm

280 mm

100 mm

250 mm

350 mm

25 mm

# FIG.7

EP 2 782 032 A2

# FIG.8

800

| NO | COORDINATE DATA | | | VOXEL PRESENCE | COMPO-NENT NO. | MATERIAL NAME | COLOR | |
|---|---|---|---|---|---|---|---|---|
| | X | Y | Z | | | | | |
| 1 | 0.1 | 0.1 | 0.1 | 0 | | | | ⌇801-1 |
| 2 | 0.2 | 0.0 | 0.0 | 0 | | | | ⌇801-2 |
| 3 | 0.3 | 0.0 | 0.0 | 1 | 1 | IRON | BLUE | ⋮ |
| 4 | 0.4 | 0.0 | 0.0 | 1 | 1 | IRON | BLUE | |
| ⋮ | ⋮ | ⋮ | ⋮ | ⋮ | ⋮ | ⋮ | ⋮ | |
| 16 | 0.4 | 0.2 | 0.2 | 1 | 3 | ALUMI-NUM | RED | |

# FIG.9

100

| 901 FIRST DESIGN INFORMATION GENERATING UNIT | 902 FIRST INFORMATION GENERATING UNIT | 903 SECOND INFORMATION GENERATING UNIT | 904 INDEX VALUE CALCULATING UNIT |
|---|---|---|---|

| 905 DETECTING UNIT | 906 PLATE MODEL GENERATING UNIT | 909 SPACE MODEL GENERATING UNIT | 910 VOLUME CALCULATING UNIT |
|---|---|---|---|

907 OPENING AREA CALCULATING UNIT

908 EXTRACTING UNIT

ANALYSIS MODEL GENERATING APPARATUS

# FIG.10

1002

1001

□ : PREDETERMINED SIZE

FIG.11A

A2

C1~Cq

FIG.11B

A1

C1~Cp

⬚ : ELEMENT

# FIG.12

DIRECTION
OF X-AXIS

A1

CS1

CSt

CS1

CS2

PORTION
WITHOUT
COMPONENT

CS3

CS4

PORTION
WITH
COMPONENT

CHANGE
PRESENT

CHANGE
PRESENT

pl1

pl2

pl3

PLATE
MODEL
GENERATION

PLATE
MODEL
GENERATION

# FIG.13

| PLATE NO | PLATE NAME | COUPLED CAVITY NO | START POINT COORDINATE DATA | | | END POINT COORDINATE DATA | | | OPENING RATE [%] | THICK-NESS [mm] | MATERIAL | |
|---|---|---|---|---|---|---|---|---|---|---|---|---|
| | | | X | Y | Z | X | Y | Z | | | | |
| 1 | PSU-RIGHT | 1 | 10.5 | -2.3 | -1.8 | 11.5 | 3.6 | 3.8 | 20.0 | 0.1 | IRON | ⁓1301-1 |
| 2 | PSU-TOP | 1, 2, 3 | -0.5 | -2.3 | 3.8 | 11.5 | 3.6 | 3.8 | 0.0 | 0.1 | IRON | ⁓1301-2 |
| 3 | PSU-FRONT | 1 | -0.5 | -2.3 | -3.2 | 11.5 | -2.3 | 3.8 | 12.0 | 0.1 | IRON | ⋮ |
| ⋮ | ⋮ | ⋮ | ⋮ | ⋮ | ⋮ | ⋮ | ⋮ | ⋮ | ⋮ | ⋮ | ⋮ | |

1300

EP 2 782 032 A2

FIG.14

EP 2 782 032 A2

# FIG.15

| CAVITY NO | CAVITY NAME | SOUND SOURCE ALLOCATION NUMBER | START POINT COORDINATE DATA | | | END POINT COORDINATE DATA | | | MEDIUM | CAVITY VOLUME [mm³] | INTRACAVITY COMPONENT VOLUME [mm³] | |
|---|---|---|---|---|---|---|---|---|---|---|---|---|
| | | | X | Y | Z | X | Y | Z | | | | |
| 1 | PSU | | -0.4 | -2.2 | -3.1 | 11.4 | 3.5 | 3.7 | AIR | 457.4 | 0 | ∿1501-1 |
| 2 | DUCT | | 2.5 | -2.2 | 3.8 | 11.4 | 3.5 | 14.2 | AIR | 527.6 | 0 | ∿1501-2 |
| 3 | FAN | 1 | -0.4 | -2.2 | 3.8 | 2.4 | 3.5 | 14.2 | AIR | 166.0 | 0 | ∿1501-3 |
| ⋮ | ⋮ | ⋮ | ⋮ | ⋮ | ⋮ | ⋮ | ⋮ | ⋮ | ⋮ | ⋮ | ⋮ | ⋮ |

CAVITY 3  CAVITY 2  (11.4,3.5,3.7)  CAVITY 1  (-0.4,-2.2,-3.1)

EP 2 782 032 A2

# FIG.16

UPPER COVER  1600

REAR SIDE
(EXHAUST SIDE)

FRONT SIDE
(INTAKE SIDE)

FAN 1
FAN 2
FAN 3
FAN 4
FAN 5

1600

SUBSTRATE

1600

EP 2 782 032 A2

# FIG.17

1700

| SOUND SOURCE NAME | SOUND SOURCE ALLOCATION NUMBER | FREQUENCY | | | | | | | | | | |
|---|---|---|---|---|---|---|---|---|---|---|---|
| | | 100 Hz | 125 Hz | 160 Hz | 200 Hz | 250 Hz | 315 Hz | 400 Hz | 500 Hz | 630 Hz | 800 Hz |
| fan-A_5V | 1 | 2.11E-09 | 1.98E-10 | 2.73E-10 | 8.00E-10 | 1.78E-09 | 2.43E-09 | 4.81E-09 | 5.42E-09 | 8.30E-09 | 1.10E-08 |
| fan-B_12V | 2 | 4.44E-10 | 9.86E-11 | 1.78E-10 | 5.00E-10 | 1.27E-09 | 1.85E-09 | 4.36E-09 | 4.37E-09 | 6.49E-09 | 9.12E-09 |
| fan-A_4.5V | 3 | 1.14E-10 | 8.99E-11 | 1.61E-10 | 3.75E-10 | 9.31E-10 | 2.03E-09 | 3.50E-09 | 3.03E-09 | 4.99E-09 | 6.34E-09 |
| fan-C_12V | 4 | 5.25E-11 | 5.32E-11 | 1.22E-10 | 2.47E-10 | 6.58E-10 | 1.25E-09 | 1.78E-09 | 2.12E-09 | 6.50E-09 | 4.57E-09 |

1701-1
1701-2

| FREQUENCY | | | | | | | | | | |
|---|---|---|---|---|---|---|---|---|---|---|
| 1000 Hz | 1250 Hz | 1600 Hz | 2000 Hz | 2500 Hz | 3150 Hz | 4000 Hz | 5000 Hz | 6300 Hz | 8000 Hz | 10000 Hz |
| 1.35E-08 | 1.73E-08 | 1.34E-08 | 2.44E-08 | 3.14E-08 | 8.81E-09 | 8.95E-09 | 3.10E-09 | 1.75E-09 | 7.23E-10 | 3.10E-10 |
| 1.06E-08 | 1.24E-08 | 1.36E-08 | 1.06E-08 | 2.01E-08 | 5.43E-09 | 5.19E-09 | 1.74E-09 | 9.57E-10 | 3.89E-10 | 1.62E-10 |
| 7.36E-09 | 7.45E-09 | 8.20E-09 | 5.93E-09 | 1.12E-08 | 3.07E-09 | 2.58E-09 | 8.49E-10 | 4.65E-10 | 1.62E-10 | 6.44E-11 |
| 4.62E-09 | 4.03E-09 | 3.99E-09 | 3.08E-09 | 5.61E-09 | 1.47E-09 | 1.14E-09 | 3.59E-10 | 1.96E-10 | 6.03E-11 | 2.22E-11 |

1701-1
1701-2

# FIG.18

START

ACQUIRE SECOND CAD DATA
REPRESENTING SECOND OBJECT — S1801

GENERATE COMPONENT-REMOVED
SPACE MODEL A2 REPRESENTING
RECTANGULAR PARALLELEPIPED
SURROUNDING SECOND OBJECT — S1802

DIVIDE COMPONENT-REMOVED
SPACE MODEL A2 INTO ELEMENTS
C1 TO Cq — S1803

j=1 — S1804

j≤q? — S1805

NO → A

YES

SELECT ELEMENT Cj — S1806

COMPONENT IN
SECOND OBJECT IS PRESENT
IN ELEMENT Cj? — S1807

NO → SET INFORMATION
INDICATING
ABSENCE OF
COMPONENT,
FOR ELEMENT Cj
S1809

YES

SET INFORMATION INDICATING
PRESENCE OF COMPONENT,
FOR ELEMENT Cj — S1808

j=j+1 — S1810

# FIG.19

A

CALCULATE CAPACITY OF EACH COMPONENT INCLUDED IN
SECOND OBJECT INDICATED BY SECOND CAD DATA ⟋ S1901

GENERATE FIRST CAD DATA REPRESENTING FIRST OBJECT
OBTAINED BY REMOVING COMPONENTS HAVING CAPACITY
LESS THAN OR EQUAL TO PREDETERMINED CAPACITY,
FROM AMONG COMPONENTS INCLUDED IN SECOND OBJECT
S1902

GENERATE COMPONENT-REMOVED SPACE MODEL A1
REPRESENTING RECTANGULAR PARALLELEPIPED
SURROUNDING FIRST OBJECT
S1903

DIVIDE COMPONENT-REMOVED SPACE
MODEL A1 INTO ELEMENTS C1 TO Cp ⟋ S1904

SELECT COMPONENT-REMOVED SPACE
MODEL A1 ⟋ S1905

$j=1$ ⟋ S1906

$j \leq p$? ⟋ S1907

NO → B

YES

SELECT ELEMENT Cj ⟋ S1908

COMPONENT IN
FIRST OBJECT IS PRESENT
IN ELEMENT Cj? ⟋ S1909

NO

YES

SET INFORMATION
INDICATING
ABSENCE OF
COMPONENT, FOR
ELEMENT Cj
S1911

SET INFORMATION INDICATING
PRESENCE OF COMPONENT, FOR
ELEMENT Cj ⟋ S1910

$j=j+1$ ⟋ S1912

30

# FIG.20

```
                              ┌───┐
                              │ B │
                              └─┬─┘
                                ▼
        ┌──────────────────────────────────────────────┐
        │  SELECT COMPONENT-REMOVED SPACE MODEL A1       │───  S2001
        └──────────────────────┬───────────────────────┘
                               │
        ┌──────────────────────▼───────────────────────┐
   NO   ╱                UNSELECTED                      ╲
 ◄──────        AXIS DIRECTION IS                          ────  S2002
        ╲                PRESENT?                         ╱
         └──────────────────────┬───────────────────────┘
                               │ YES
        ┌───┐  ┌───────────────▼───────────────────────┐
        │ E │  │      SELECT ONE AXIS DIRECTION,         │───  S2003
        └───┘  │ FROM AMONG UNSELECTED AXIS DIRECTIONS   │
               └────────────────┬───────────────────────┘
                                ▼
        ┌───────────────────────────────────────────────┐
        │  GENERATE SECOND INFORMATION THAT               │
        │ INDICATES CROSS SECTIONS OF RECTANGULAR         │
        │ PARALLELEPIPED REPRESENTED BY COMPONENT-        │───  S2004
        │ REMOVED SPACE MODEL A1 ORTHOGONAL TO            │
        │       SELECTED AXIS DIRECTION                    │
        └───────────────────────┬───────────────────────┘
                                ▼
        ┌───┐  ┌────────────────────────────────────────┐
        │ D │  │ FOR EACH CROSS SECTION, CALCULATE CROSS- │
        └───┘  │  SECTIONAL AREA OF PORTION WITHOUT       │───  S2005
               │      COMPONENT IN CROSS SECTION          │
               └────────────────┬───────────────────────┘
                                ▼
        ┌───────────────────────────────────────────────┐
        │                  i=1                            │───  S2006
        └───────────────────────┬───────────────────────┘
                                ▼
   NO   ╱                      i≦                         ╲
 ◄──────              NUMBER OF                             ────  S2007
        ╲            CROSS SECTIONS?                       ╱
         └──────────────────────┬───────────────────────┘
                               │ YES
        ┌──────────────────────▼───────────────────────┐
        │        SELECT CROSS SECTION CSi                │───  S2008
        └──────────────────────┬───────────────────────┘
                              ┌─▼─┐
                              │ C │
                              └───┘
```

31

# FIG.21

C

S2101
CROSS SECTION
CS(i-1) EXISTS?

NO →

S2102
GENERATE PLATE MODEL REPRESENTATIVE OF PLATE THAT INCLUDES PORTION WITHOUT COMPONENT IN CROSS SECTION CSi

YES

S2104
COMPARE CROSS-SECTIONAL AREA OF CROSS SECTION CSi AND CROSS-SECTIONAL AREA OF CROSS SECTION CS(i-1)

S2103
GENERATE PLATE MODEL REPRESENTATIVE OF PLATE THAT INCLUDES PORTION WITH COMPONENT IN CROSS SECTION CSi

S2105
DIFFERENCE IN CROSS-SECTIONAL AREAS EXCEEDS PREDETERMINED VALUE?

NO →

YES

S2106
GENERATE PLATE MODEL REPRESENTATIVE OF PLATE THAT INCLUDES PORTION WITHOUT COMPONENT IN CROSS SECTION CSi

GENERATE PLATE MODEL REPRESENTATIVE OF PLATE THAT INCLUDES PORTION WITH COMPONENT IN CROSS SECTION CSi

S2107

YES

CROSS SECTION
CS(i+1) EXISTS?  S2108

NO

S2109
GENERATE PLATE MODEL REPRESENTATIVE OF PLATE THAT INCLUDES PORTION WITHOUT COMPONENT IN CROSS SECTION CSi

S2110
GENERATE PLATE MODEL REPRESENTATIVE OF PLATE THAT INCLUDES PORTION WITH COMPONENT IN CROSS SECTION CSi

i=i+1  S2111

D

# FIG.22

E

GENERATE SPACE MODEL REPRESENTATIVE OF SPACE SURROUNDED BY PLATES REPRESENTED BY PLATE MODELS ⟶ S2201

UNSELECTED SPACE MODEL IS PRESENT? ⟶ S2202

NO

F

YES

SELECT ONE SPACE MODEL FROM AMONG UNSELECTED SPACE MODELS ⟶ S2203

SPACE MODEL EXISTS THAT REPRESENTS SPACE OVERLAPPING SPACE REPRESENTED BY SELECTED SPACE MODEL? ⟶ S2204

NO

YES

CALCULATE RESPECTIVE CAPACITIES OF SELECTED SPACE MODEL AND SPACE MODEL REPRESENTATIVE OF OVERLAPPING SPACE ⟶ S2205

DELETE PORTION OF SPACE REPRESENTED BY SPACE MODEL HAVING SMALLER CAPACITY, FROM SPACE MODEL WITH LARGER CAPACITY ⟶ S2206

# FIG.23

```
                    ┌───────┐
                    │   F   │
                    └───┬───┘
                        │
        ┌───────────────┤
        │               ▼
        │        ╱───────────────╲
    NO  │       ╱    UNSELECTED    ╲
    ◄───┼──────    SPACE MODEL IS    ───────  S2301
        │       ╲     PRESENT?      ╱
        │        ╲───────────────╱
   ┌────▼───┐         │
   │   G    │         │ YES
   └────────┘         ▼
        ┌──────────────────────────────────┐
        │ SELECT ONE SPACE MODEL FROM AMONG │──── S2302
        │    UNSELECTED SPACE MODELS        │
        └─────────────────┬────────────────┘
                          ▼
        ┌──────────────────────────────────┐
        │ CALCULATE VOLUME OF SPACE REPRESENTED │── S2303
        │    BY SELECTED SPACE MODEL        │
        └─────────────────┬────────────────┘
                          ▼
        ┌──────────────────────────────────┐
        │ CALCULATE VOLUME OF COMPONENT INCLUDED IN │── S2304
        │ SPACE REPRESENTED BY SELECTED SPACE MODEL │
        └─────────────────┬────────────────┘
                          ▼
        ┌──────────────────────────────────┐
        │ SUBTRACT VOLUME OF COMPONENT FROM │
        │ VOLUME OF SPACE TO CALCULATE VOLUME OF │── S2305
        │ PORTION WITHOUT COMPONENT IN SPACE │
        │    REPRESENTED BY SPACE MODEL     │
        └─────────────────┬────────────────┘
                          ▼
        ┌──────────────────────────────────┐
        │ CORRELATE AND OUTPUT SELECTED SPACE MODEL, │
        │ VOLUME OF PORTION WITHOUT COMPONENT IN │
        │ SPACE REPRESENTED BY SELECTED SPACE MODEL, │── S2306
        │ AND VOLUME OF PORTION WITH COMPONENT │
        │            IN SPACE               │
        └─────────────────┬────────────────┘
                          │
        └─────────────────┘
```

# FIG.24

```
                              ┌──┐
                              │ G│
                              └──┘
                               │
                               ▼
         NO          ╱◇◇◇◇◇◇◇◇◇◇◇◇◇◇◇◇◇◇◇◇╲
    ┌────────────────    UNSELECTED          ╲
    │              ╲    PLATE MODEL IS        ╱ ─── S2401
    │               ╲    PRESENT?           ╱
    │                ╲◇◇◇◇◇◇◇◇◇◇◇◇◇◇◇◇◇◇◇◇◇╱
    ▼                          │
  ┌─────┐                      │ YES
  │ END │                      ▼
  └─────┘          ┌───────────────────────────┐
                   │    SELECT ONE PLATE MODEL  │ ─── S2402
                   │ FROM UNSELECTED PLATE MODELS│
                   └───────────────────────────┘
                               │
                               ▼
                   ┌───────────────────────────┐
                   │IDENTIFY COMPONENT IN SECOND OBJECT│
                   │  OVERLAPPING PLATE REPRESENTED   │ ─── S2403
                   │     BY SELECTED PLATE MODEL      │
                   └───────────────────────────┘
                               │
                               ▼
                   ┌───────────────────────────┐
                   │ CALCULATE AREA OF PORTION PARALLEL│
                   │TO AND OVERLAPPING PLATE REPRESENTED│ ─── S2404
                   │BY PLATE MODEL IN IDENTIFIED COMPONENT│
                   └───────────────────────────┘
                               │
                               ▼
                   ┌───────────────────────────┐
                   │     CALCULATE AREA OF PLATE     │ ─── S2405
                   │   REPRESENTED BY PLATE MODEL    │
                   └───────────────────────────┘
                               │
                               ▼
                   ┌───────────────────────────┐
                   │ SUBTRACT AREA OF OVERLAPPING PORTION│
                   │FROM CALCULATED AREA OF PLATE TO CALCULATE│ ─── S2406
                   │AREA OF PORTION NOT OVERLAPPING COMPONENT│
                   │            IN PLATE            │
                   └───────────────────────────┘
                               │
                               ▼
                   ┌───────────────────────────┐
                   │IDENTIFY COMPONENT HAVING LARGEST AREA│
                   │ OF OVERLAPPING PORTION AMONG IDENTIFIED│ ─── S2407
                   │           COMPONENTS           │
                   └───────────────────────────┘
                               │
                               ▼
                   ┌───────────────────────────┐
                   │ EXTRACT MATERIAL OF IDENTIFIED LARGEST│ ─── S2408
                   │  COMPONENT FROM SECOND CAD DATA │
                   └───────────────────────────┘
                               │
                               ▼
                   ┌───────────────────────────┐
                   │CORRELATE AND OUTPUT SELECTED PLATE MODEL,│ ─── S2409
                   │ CALCULATED AREA, AND EXTRACTED MATERIAL│
                   └───────────────────────────┘
                               │
    └──────────────────────────┘
```

**EP 2 782 032 A2**

**REFERENCES CITED IN THE DESCRIPTION**

**Patent documents cited in the description**

- JP 2001264156 A